# FASCICULE DE BREVET EUROPEEN

(11) **EP 2 044 137 B1**
(45) Date de publication et mention de la délivrance du brevet: **04.03.2015**
(21) Numéro de dépôt: 07787801.5
(22) Date de dépôt: 23.07.2007
(51) Int. Cl.: C08G 18/79, C08J 7/18, C08G 18/00, C08G 65/18, C09D 175/04, G03F 7/075, C08G 59/22, G03F 7/038

(54) **COMPOSITION POLYMERISABLE ET/OU RETICULABLE SOUS IRRADIATION PAR VOIE CATIONIQUE ET/OU RADICALAIRE**
ZUSAMMENSETZUNG, DIE BEI BESTRAHLUNG KATIONISCH UND/ODER RADIKALISCH POLYMERISIERT UND/ODER VERNETZT WERDEN KANN
COMPOSITION THAT CAN BE POLYMERIZED AND/OR CROSSLINKED WHEN IRRADIATED BY CATIONIC AND/OR RADICAL ROUTE

(30) Priorité: 25.07.2006 FR 0606789
(43) Date de publication de la demande: 08.04.2009
(73) Titulaire: Vencorex France, 69800 Saint-Priest (FR)
(72) Inventeur: FRANCES, Jean-Marc, F-69330 Meyzieu (FR); BARBEAU, Philippe, F-69740 Genas (FR); BERNARD, Jean-Marie, F-69440 Saint Laurent D'agny (FR); BOURGEOIS, Damien, F-30390 ARAMON (FR)
(74) Mandataire: Colombet, Alain André
(86) Numéro de dépôt international: PCT/EP2007/057557
(87) Numéro de publication internationale: WO 2008/012281

(56) Documents cités:
- FR-A1- 2 761 368
- FR-A1- 2 849 446
- US-B1- 6 261 665

## Description

L'invention concerne une composition polymérisable et/ou réticulable sous irradiation par voie cationique et/ou radicalaire. Elle concerne plus particulièrement une composition polymérisable et/ou réticulable comprenant au moins un composé de base, au moins un photoamorceur et au moins un composé comprenant au moins une fonction isocyanate, et son utilisation comme revêtement.

Le domaine de l'invention est celui des systèmes photopolymères réticulables et/ou polymérisables sous irradiation, en particulier sous irradiation UV ou par faisceau d'électrons, utilisables, notamment, pour former notamment des revêtements, tels que des encres, des vernis ou des peintures.

Ces compositions sont du type de celles comprenant une matrice organique dont les constituants sont porteurs de fonctions réactives de polymérisation/réticulation, ainsi qu'un photo-amorceur ou photo-initiateur qui, après absorption d'énergie, par exemple UV, libère un acide fort : H⁺ (voie cationique) ou un radical libre (voie radicalaire). Les photo-amorceurs cationiques permettent ainsi l'initiation et la propagation de polymérisations en chaîne cationiques, tandis que les photo-amorceurs (PA) radicalaires permettent le déclenchement de polymérisations en chaîne par formation de radicaux libres.

Dans le domaine des revêtements de type vernis, en particulier dans le domaine des vernis d'emballages métalliques tels que canettes pour boisson, on cherche des composés susceptibles d'améliorer la flexibilité des revêtements, sans diminuer la réactivité des systèmes ni la résistance chimique et mécanique (résistance aux rayures notamment) du revêtement.

Des compositions polymérisables/réticulables sous irradiation UV cationique sont connues et sont utilisées comme revêtement tels que des vernis. De telles compositions ont par exemple pour matrice organique un composé comprenant des fonctions epoxydes aliphatiques, et un photoamorceur cationique. Une couche de vernis à base d'une telle composition, déposée sur un support en aluminium par exemple, présente une bonne résistance chimique et mécanique (résistance aux rayures), mais une flexibilité (souplesse) insuffisante.

Ainsi, la présente invention propose une composition ne présentant pas ces inconvénients.

A cet effet l'invention propose, selon un premier objet, une composition polymérisable et/ou réticulable sous irradiation, de préférence actinique et/ou par faisceau (x) d'électrons, par voie cationique et/ou radicalaire comprenant :
- A) au moins un composé de base comportant, par molécule, au moins un groupement de polymérisation/réticulation, les groupements étant choisis dans la liste suivante : époxy, oxétanne, alcényle, dioxolanne, episulfure, thioxolanne, acrylate ou méthacrylate, hydroxy ;
- B) au moins un photoamorceur cationique et/ou radicalaire
- C) éventuellement au moins un composé comprenant une fonction alcool ou thiol ou acide carboxylique
- D) au moins un composé comprenant au moins une fonction isocyanate Dans la présente invention, l'irradiation par voie cationique est préférée.

Avantageusement le composé de base comprend au moins deux groupements de polymérisation/réticulation, ces deux groupements étant de préférence sélectionnés dans le groupe des associations de groupements suivantes : époxy-époxy, oxétanne-oxétanne, dioxolanne-dioxolanne.

Les groupements époxy, oxétanne et dioxolanne de l'invention sont de préférence des groupements aliphatiques. Les groupements époxy sont encore plus préférentiellement cycloaliphatiques.

Les composés de base ayant deux groupements époxy, oxétanne, ou dioxolanne sont des composés hydrocarbonés pouvant comprendre des fonctionnalités ester, amide, carbamate, carbonate, carbonyl etc.

Avantageusement le composé de base avec des groupements epoxy est choisi parmi les composés suivants :

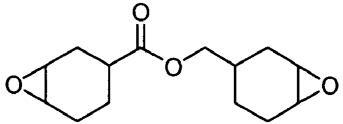

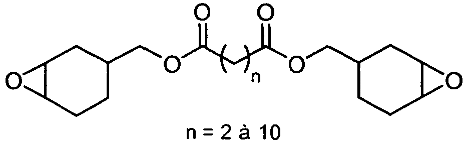

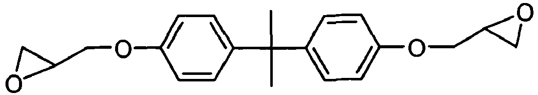

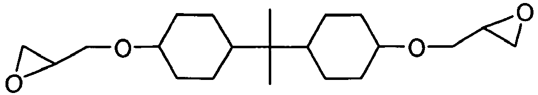

Selon un mode de réalisation particulier de l'invention, le composé de base est un oligomère et/ou polymère silicone réticulable et/ ou polymérisable liquide à température ambiante ou thermofusible à température inférieure à 100° C, l'oligomère et/ou polymère silicone comprenant :
au moins un motif de formule suivante :

   Z (R⁰)ₐSiO_{3-a/2}

   dans laquelle :
   ~ a = 0, 1 ou 2,
   ~ R⁰, identique ou différent, représente un radical alkyle, cycloalkyle, aryle, vinyle, hydrogéno, hydroxy, alcoxy, de préférence un alkyle inférieur en C₁-C₆,
   ~ Z, est un substituant organique comportant au moins une fonction réactive époxy, et/ou alcénylether et/ou oxétanne et/ou dioxolane et/ou carbonate,
   et au moins deux atomes de silicium.

Les fonctions réactives Z du polymère ou oligomère silicone peuvent être très variées. Toutefois, des revêtements particulièrement intéressants sont obtenus lorsque l'oligomère ou polymère silicone comprend au moins un motif (FS) dans lequel Z représente un substituant organique Z1 comportant au moins une fonction réactive époxy, et/ou dioxolane, et de préférence au moins une fonction réactive époxy.

Selon deux alternatives avantageuses de la présente invention, l'oligomère ou polymère silicone avec au moins une fonction réactive Z1 époxy et/ou dioxolane, et de préférence au moins une fonction réactive Z1 époxy peut :
(i) soit comporter uniquement ce(s) type(s) de fonction(s) réactive(s) Z1,
(ii) soit comporter d'autres fonctions réactives Z telles que les fonctions réactives Z2 alcényléther, oxétanne et/ou carbonate.

Dans le cas de la première alternative (i), la composition peut également comprendre d'autres oligomères et/ou polymères silicones et différents de l'oligomère/polymère décrit ci-dessus comportant d'autres fonctions réactives Z2 telles que les fonctions alcényléther, oxétanne et/ou carbonate et éventuellement des fonctions réactives Z1.

A titre d'exemples de fonctions réactives Z, celles ci peuvent être notamment choisies parmi les radicaux suivants :

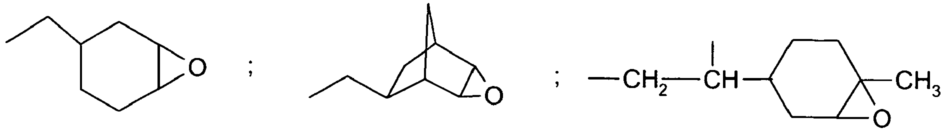

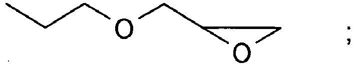

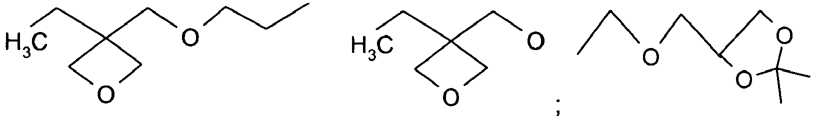

-(CH₂)₃-O-CH=CH₂ ;

-(CH₂)₃-O-CH=CH-R"

- avec R" représentant un radical alkyle linéaire ou ramifié en C₁-C₆.

Selon une deuxième variante avantageuse de la présente invention, le polymère ou oligomère silicone est constitué par au moins une silicone de formule moyenne suivante :
a) 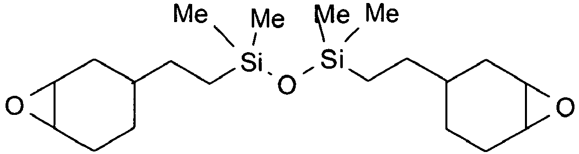
b) 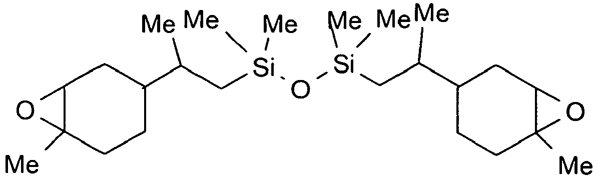
c) 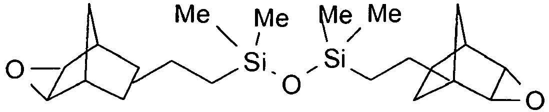
d) 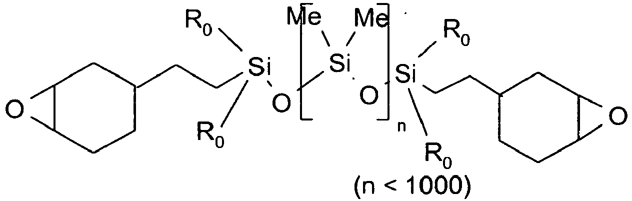
e) 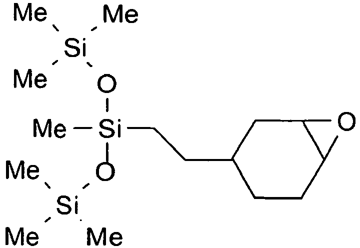
f) 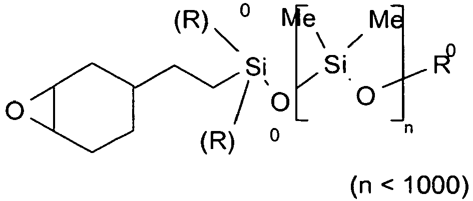
g) 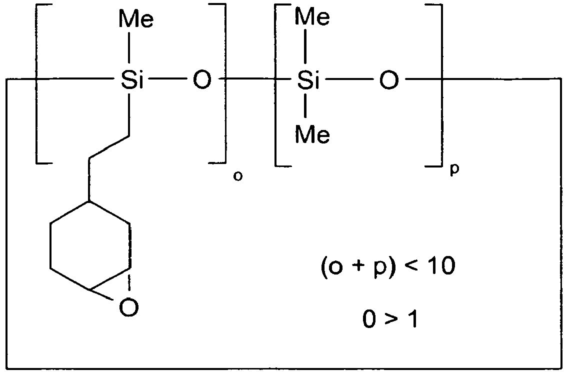
h) 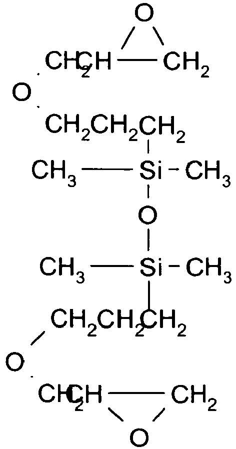
i) 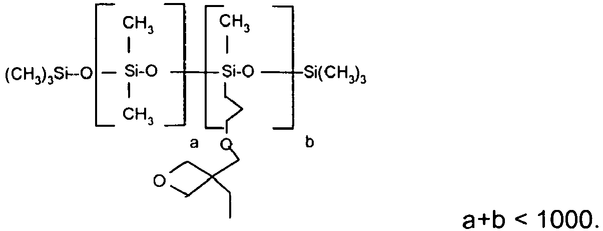
j) 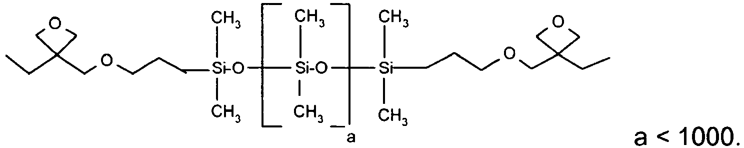
k) 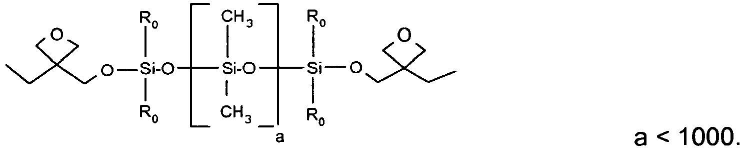
l) 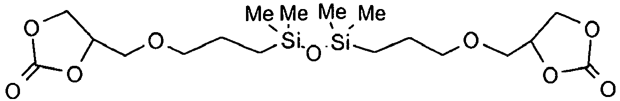
m) 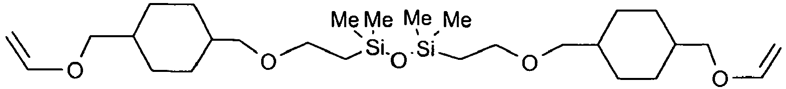
n)

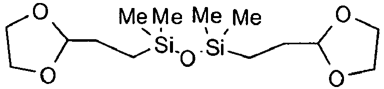

Dans ces formules R₀ ou (R)⁰ = alkyle (de préférence C₁-C₁₀) ou aryle (de préférence phényle).

Par "alcényl", on entend une chaîne hydrocarbonée insaturée, linéaire ou ramifiée, substituée ou non, présentant au moins une double liaison oléfinique, et plus préférablement une seule double liaison. De préférence, le groupe "alcényl" présente de 2 à 8 atomes de carbone, mieux encore de 2 à 6. Cette chaîne hydrocarbonée comprend éventuellement au moins un hétéroatome tel que O, N, S.

Des exemples préférés de groupes "alcényl" sont les groupes vinyle, allyle et homoallyle ; le vinyle étant particulièrement préféré.

Lorsque le composé de base comprend des groupements alcényles, il peut s'agir de groupements alcényles « activés » tels que des alcényléther ou styrène, qui vont polymériser en présence du photoamorceur, notamment cationique. Il peut s'agir également de groupements alcényles « non activés » tels que des groupements allyliques. Ces groupements alcényles « non activés » peuvent polymériser en présence d'un photoamorceur radicalaire et d'un composé comprenant des fonctions thiols. On peut citer à titre d'exemple d'une telle réaction la photopolymerisation thiol-ènes. Une telle réaction est décrite dans la publication « Photopolymerization of thiol-enes : some recent advances » (Rad Tech 2001, October 8-10,2001, Conférence proceedings, p.219-224).

Selon un autre mode de réalisation particulier de l'invention, au moins un des groupements du composé de base est un groupement alcényl éther linéaire ou cyclique. Dans ce cas, le composé de base est avantageusement choisi dans la liste suivante :
- les vinyl-éthers, en particulier l'éther de triéthylène glycol divinylique (RAPIDCURE® CHVE-3, GAF Chemicals Corp.), les éthers vinyliques cycliques ou les tétramères et/ou dimères d'acroléines et le vinyl-éther de formule suivante : 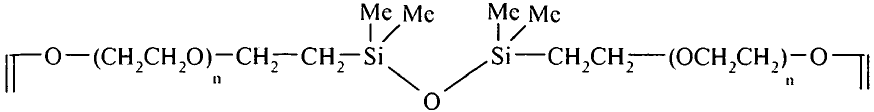
- les propényl-éthers,
et les butényl-éthers,

Selon un mode de réalisation particulier de l'invention, le composé de base comprend également des fonctions (ou des précurseurs de ces fonctions) pouvant polymériser avec les fonctions isocyanate du composé D. Il peut s'agir de fonctions alcool ou thiol par exemple. Le composé de base peut par exemple comprendre au moins un groupement epoxy et/ou oxétanne, et également une fonction alcool. On peut citer à titre d'exemple d'un tel composé de base le glycidol et le triméthylol propane oxétanne.

Selon un mode de réalisation particulier de l'invention, au moins un des groupements du composé de base est un groupement acrylate ou méthacrylate. Dans ce cas, le composé de base est avantageusement choisi dans la liste suivante :
- acrylates époxydés, de préférence l'oligomère de Bisphénol-A-époxydiacrylate (EBECRYL 600),
- acrylo-glycéro-polyester, de préférence mélange d'oligomère d'acrylate trifonctionnel obtenu à partir de glycérol et de polyester (EBECRYL 810),
- acrylates multifonctionnels, de préférence pentaérythritol triacrylate (PETA), triméthylol propane triacrylate (TMPTA), 1,6-hexanediol diacrylate (HDDA), triméthylolpropane éthoxylate triacrylate, thiodiéthylèneglycol diacrylate, tétra éthylène glycol diacrylate (TEGDA), tripropylène-glycol diacrylate (TPGDA), triéthylène-glycol diacrylate (TEGDA), triméthylpropane triméthacrylate (TMPTMA),
- acrylo-uréthanes,
- acrylo-polyéthers,
- acrylo-polyesters,
- polyesters insaturés,
- acrylo-acryliques,

Selon encore un autre mode de réalisation particulier de l'invention, au moins un des groupements du composé de base est un groupement hydroxy. Dans ce cas, le composé de base est avantageusement un polyol de formule :

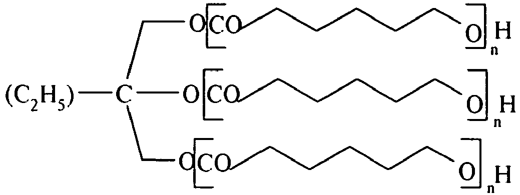

Le composé de base peut également être un oligomère ou un polymère.

Le composé de base comprend les groupements de réticulation/polymérisation mentionnés ci-dessus, ou des précurseurs de ces groupements.

L'initiation de la photopolymérisation et/ou réticulation de la composition selon l'invention est rendue possible grâce à la présence du photoamorceur ou photoinitiateur cationique et/ou radicalaire. Ces photoamorceurs ou photoinitiateurs sont bien connus de l'homme du métier. La composition de l'invention comprend une quantité efficace de photoamorceur. Par quantité efficace, on entend une quantité suffisante pour amorcer la réticulation.

Les photoamorceurs cationiques sont généralement des sels d'onium. L'entité cationique du photoamorceur peut par exemple être un iodonium, un sulfonium (mono- ou polysulfonium), un oxoisothiochromanium etc. De telles entités cationiques sont par exemple décrites dans le document FR2761368. L'entité anionique du photoamorceur peut par exemple être un borate tel que décrit dans le document FR2761368. Il peut également s'agir par exemple d'un hexafluoro antimonate, d'un hexafluorophosphate, d'un trifluorométhylsulfonate etc.

Les photoamorceurs radicalaires sont bien connus et sont généralement à base de benzophénones ou de cétones aromatiques telles que la 2-hydroxy-2-méthyl-1-phényl-propane-1-one.

Selon un mode de réalisation particulier de l'invention, la composition comprend un composé C ayant au moins une fonction alcool ou thiol ou acide carboxylique, de préférence alcool ou thiol. L'alcool est avantageusement primaire ou secondaire. Cet alcool peut également être utilisé comme solvant du photoamorceur.

Avantageusement l'alcool est choisi dans le groupe suivant : alcools isopropyliques, alcools benzyliques, diacétone alcool, cyclohexanol, lactate de butyle et le le triméthylol propane oxétanne.

L'alcool peut être choisi également parmi les polyols tels que des diols, triols ou polyols. On peut citer à titre d'exemples non limitatifs le butane diol, l'hexanediol, les cyclohexanediol, le glycérol, le pentaérythritol, le triméthylolpropane.

Le composé porteur d'au moins une fonction alcool peut aussi être choisi parmi les polymères polyols tels que les polyols à structure polyester ou polyacrylique ou polyéther ou polyamide.

Le composé comprenant une fonction thiol peut être un polythiol.

A titre de composé comprenant au moins une fonction thiol on peut citer par exemple le butanethiol, l'hexanethiol, le 1,3 glycéryl dithioglycolate, le 1,6 di thio hexane, le 1,8 dimercapto 3,6 dioxaoctane etc.

Le composé peut comprendre à la fois une fonction thiol et une fonction alcool. On peut citer à titre d'exemples le mercaptoéthanol, le thioglycérol etc..

Le composé C peut également être un oligomère ou un polymère.

La composition de l'invention comprend un composé comprenant au moins une fonction isocyanate. Ce composé est avantageusement un polyisocyanate.

Par polyisocyanate, on entend un composé comprenant au moins deux fonctions isocyanate.

Le polyisocyanate de l'invention est de préférence un polyisocyanate de formule (I) suivante :

Y-(-N=C=O)ₙ

dans laquelle Y est un groupement polyvalent substitué ou non, comprenant ou non des hétéroatomes, aromatique, aliphatique, cycloaliphatique ou hétérocyclique et n est au moins égal à 1. Des exemples de polyisocyanates pouvant convenir sont l'isophorone diisocyanate, le 1,3- et 1,4-cyclohexane diisocyanate, le 1,2-éthylène diisocyanate, le 1,4-tétraméthylène diisocyanate, le 1,6-hexaméthylène diisocyanate, le 2,2,4 et 2,4,4-triméthyl-1,6-hexaméthylène diisocyanate, le 1,12-dodécane diisocyanate, le α,α'-diisocyanatodipropyl éther, le 1,3-cyclobutane diisocyanate, le 2,2- et 2,6-diisocynanato-1-méthylcyclohexane, le 2,5 et 3,5-bis(isocyanatométhyl)-8-méthyl-1,4-méthano-décahydronaphthalène, le 1,5-, 2,5-, 1,6- et 2,6-bis(isocyanatométhyl)-4,7-méthanohexahydroindane, le 1,5-, 2,5- et 2,6-bis (isocyanato)-4,7-méthanehexahydroindane, le 2,4'- et 4,4'-dicyclohexyl diisocyanate, le 2,4- et 2,6-hexahydrotolylène diisocyanate, le perhydro-2,4'- et 4,4'-diphénylméthane diisocyanate, le alpha.,.alpha.'-diisocyanato-1,4-diéthylbenzène, le 1,3-et 1,4-phénylène diisocyanate, le 4,4'-diisocyanatobiphényl, le 4,4'-diisocyanato-3,3'-dichlorobiphényl, le 4,4'-diisocyanato-3,3'-diméthoxybiphényl, le 4,4'-diisocyanato-3,3'-diméthylbiphényl, le 4,4'-diisocyanato-3,3'-diphénylbiphényl, le 2,4'- et 4,4'-diisocyanato diphénylméthane, le naphthylène 1,5-diisocyanate, le 2,4- et 2,6-toluène diisocyanate, le N,N'-(4,4'-diméthyl-3,3'-diisocyanatodiphényl)uretdione, le m-xylylène diisocyanate, le dicyclohexylméthane diisocyanate, le tétraméthylxylylène diisocyanate, le 2,4,4'-triisocyanatodiphényl éther, le 4,4',4"-triisocyanatotriphénylméthane, et les analogues et mélanges. Il peut s'agir d'oligomères polyisocyanates. Comme exemples de tels oligomères polyisocyanates, on peut citer les trimères isocyanurates (HDI-trimères) tels que le Tolonate HDT® de la société Rhodia, les biurets tels que le tolonate HDB® de la société RHODIA. D'autres exemples d'oligomères isocyanate sont les oligomères isocyanate aliphatiques tels que le trimère hexaméthylène diisocyanate asymétrique, ainsi que les dérivés d'hexaméthylène diisocyanate de haute fonctionnalité et de faible viscosité, et les dimères et trimères de norbornène diisocyanate.

Selon un mode particulier de réalisation de l'invention, le polyisocyanate est un mélange de composés polyisocyanates de fonctionnalité moyenne comprise entre 2 et 8 (bornes incluses), de préférence de fonctionnalité comprise entre 3 et 7 (bornes incluses). On définit la fonctionnalité comme le nombre moyen de fonctions isocyanates portées par chacune des molécules constitutives du mélange.

On peut citer comme exemple de mélanges de polyisocyanate les trimères isocyanurates tels que l'hexaméthylène diisocyanate trimère (HDT) dont la fonctionnalité moyenne est d'environ 3,5.

On peut également utiliser les dérivés polyisocyanates isocyanurates du toluène diisocyanate (TDI) ou ou les polymères du méthane diphényl isocyanate (MDI).

Selon un autre mode de réalisation préférentiel de l'invention, le polyisocyanate est un diisocyanate, c'est-à-dire un polyisocyanate comprenant deux fonctions isocyanates, ou un triisocyanate, c'est-à-dire un polyisocyanate comprenant trois fonctions isocyanates.

Le polyisocyanate de l'invention est avantageusement aliphatique ; et de préférence choisi parmi l'hexaméthylène diisocyanate et ses dérivés.

Le composé comprenant au moins une fonction isocyanate de l'invention présente avantageusement une viscosité (25°C et à 100% d'extrait sec) comprise entre 10 et 50000 mPa.s, de préférence comprise entre 100 et 20000 mPa.s.

Selon un mode de réalisation particulier de l'invention, le composé comprenant au moins une fonction isocyanate est différent d'un prépolymère ou d'un polymère.

Les composés polyisocyanates peuvent éventuellement comporter d'autres fonctions telles que des liaisons urée et/ou biuret, et/ou carbamate et/ou allophanate et/ou ester et/ou carbonates et/ou ether et/ou amide et/ou acylurée.

La composition de l'invention peut également comprendre au moins un photosensibilisateur sélectionné parmi parmi les produits (poly)aromatiques - éventuellement métalliques - et les produits hétérocycliques et, de préférence, choisis dans la liste de produits suivants : phénothiazine, tétracène, pérylène, anthracène, diphényl-9-10-anthracène, thioxanthone, 2-chlorothioxanthen-9-one, 1-chloro 4 propoxy 9H-thioxanthen-9-one, isopropyl-OH-thioxanten-9-one, mélange isomères 2 et 4, 2-isopropyl-9H -thioxanthen-9-one, benzophénone, [4-(4-méthylphénylthio)phényl]phénylméthanone, 4-benzyl-4'-méthyldiphénylsulphide, acétophénone, xanthone, fluorénone, anthraquinone, 9,10-diméthylanthracène, 2-éthyl-9,10-diméthyloxyanthracène, 2,6-diméthyl-naphtalène, 2,5-diphényl-1-3-4-oxadiazole, xanthopinacol, 1,2-benzanthracène, 9-nitro-anthracène, et leurs mélanges.

La composition de l'invention peut également comprendre d'autres additifs, tels que des colorants, des charges (silicones ou non), des tensioactifs, des charges minérales de renforcement (siliceuses ou non), des bactéricides, des inhibiteurs de corrosion, des bases liantes, des composés organosiliciés ou des composés époxydés, tels que des alcoxysilanes, époxycycloaliphatiques ou époxyétheraliphatiques, des agents de flexibilisation, des agents de nivellement, des agents promoteurs d'adhérence, des pigments etc.

Dans le cas des compositions polymérisable/réticulable sous irradiation par voie cationique de l'invention, la proportion (en poids par rapport au poids de la composition) des composés A, B, C, D dans la composition de l'invention est avantageusement la suivante :
- composé A : supérieure ou égale à 30%, de préférence supérieure ou égale à 50%, encore plus préférentiellement supérieure ou égale à 70%
- composé B: comprise entre 0,1% et 10% (bornes incluses), de préférence comprise entre 0,5 et 5% (bornes incluses)
- composé C : inférieure ou égale à 80%, de préférence inférieure ou égale à 50%, encore plus préférentiellement inférieure ou égalé à 20%, ultimement comprise entre 5 et 10% (bornes incluses)
- composé D : comprise entre 1 et 70% (bornes incluses), de préférence comprise entre 1.5 et 50% (bornes incluses), encore plus préférentiellement comprise entre 2 et 30% (bornes incluses)

Dans le cas des compositions polymérisable/réticulable sous irradiation par voie radicalaire de l'invention, la proportion (en poids par rapport au poids de la composition) des composés A, B, C, D dans la composition de l'invention est avantageusement la suivante :
- composé A : supérieure ou égale à 30%, de préférence supérieure ou égale à 50%, encore plus préférentiellement supérieure ou égale à 70%
- composé B: comprise entre 0,01% et 10% (bornes incluses), de préférence comprise entre 0,1 et 5% (bornes incluses),
- composé C : inférieure ou égale à 80%, de préférence inférieure ou égale à 50%, encore plus préférentiellement inférieure ou égale à 20%,
- composé D : comprise entre 1 et 70% (bornes incluses), de préférence comprise entre 1.5 et 50% (bornes incluses), encore plus préférentiellement comprise entre 2 et 30% (bornes incluses)

L'invention concerne également, dans un second objet, un procédé de revêtement d'un support, caractérisé en ce que l'on applique la composition décrite ci-dessus sur un support.

Il peut s'agir de tout type de support connu. On peut citer à titre d'exemples de support des supports en bois, en plastique, en métal tel que l'aluminium ou l'acier etc. Le support est avantageusement métallique.

Avantageusement, le procédé comprend les étapes suivantes :
- enduire le support à l'aide de la composition telle que décrite ci-dessus pour former au moins une couche de revêtement (au moins partielle) sur le support
- faire réticuler la couche de revêtement sous irradiation

La composition de l'invention peut être appliquée sur le support par exemple par tout moyen d'enduction ou de transfert approprié (par exemple racle, cylindre d'enduction, héliogravure, sérigraphie dynamique, pinceau, pulvérisation : pistolet pneumatique ou électrostatique, etc...).

La réticulation du revêtement appliqué sur le support à revêtir peut être activée, par exemple en chauffant le support imprégné, voire revêtu, à une température comprise entre 30 et 250° C, de préférence comprise entre 50 et 250°C, en tenant bien évidemment compte de la résistance maximale du support à la chaleur. La durée du chauffage du support est généralement comprise entre 30 secondes et une heure. Lorsque la durée du chauffage du support est de courte durée, par exemple comprise entre 30 secondes et quelques minutes, la température maximale atteinte par le support est avantageusement comprise entre 30 et 150°C, de préférence entre 50 et 150°C.

Les moyens d'activation thermique sont du type de ceux connus et appropriés à cette fin, par exemple four ou rayonnement I.R.

Lors de la mise en oeuvre d'un procédé classique d'irradiation cationique par exemple en présence d'un monomère et d'un photoamorceur, certaines zones du revêtement ne sont parfois pas irradiées, et donc non polymérisées.

Or la mise en oeuvre du composé D comprenant une fonction isocyanate dans l'invention permet la polymérisation des zones du revêtement qui n'ont pas été irradiées. Ce qui représente un avantage important en termes de propriétés du revêtement.

La composition de l'invention peut également être une composition d'adhésif utilisée pour la mise en oeuvre de matériaux laminés (comme par exemple dans le cas de matériaux pour l'emballage). La composition est alors appliquée sur un support, irradiée sous UV afin d'obtenir une couche d'adhésif sec au toucher et par là même transportable sous forme de rouleau par exemple. Le support ainsi revêtu peut alors être remis en oeuvre ultérieurement par laminage pour former un système multicouche, puis par tout autre procédé permettant d'obtenir un objet de forme tridimensionnelle de forme recherchée. La raideur du matériau final est alors obtenue par activation thermique de l'adhésif telle que décrite ci-dessus. Les deux étapes d'irradiation et d'activation thermique, qui peuvent être découplées, apportent une souplesse aux procédés de préparation de supports revêtus.

Le taux de dépôt de la composition sur le support varie en fonction du domaine d'application de la composition. Dans le domaine des revêtements en général, le taux de dépôt est habituellement inférieur ou égal à 80 g/m². Dans le domaine des vernis de boîtes d'emballage métalliques telles que canettes de boisson, le taux de dépôt est généralement compris entre 2 et 30 g/m².

La présente invention concerne également, dans un troisième objet, le support revêtu (ou composite) susceptible d'être obtenu selon le procédé décrit ci-dessus.

Ce composite est caractérisé en ce qu'il comprend :
- un support
- au moins une couche de revêtement (au moins partielle) obtenue à partir de la composition telle que définie ci-dessus

La (les) couche(s) de revêtement de ce composite présente(nt) de bonnes propriétés en termes de résistance chimique, de résistance mécanique (notamment aux rayures), mais également de souplesse et de flexibilité.

La (les) couche(s) de revêtement de ce composite présente de bonnes propriétés de résistance aux rayons UV, et une bonne tenue (durabilité).

L'invention concerne dans un quatrième objet tout article manufacturé comportant du composite tel que décrit ci-dessus. Il peut s'agir par exemple de tôle métallique, de boîtes d'emballage métalliques telles que des canettes de boisson etc.

L'invention concerne dans un cinquième objet l'utilisation de la composition de l'invention comme vernis, adhésif ou encre. Elle concerne en particulier l'utilisation comme vernis pour boîte d'emballage métallique.

Enfin l'invention concerne dans un sixième objet l'utilisation d'un composé comprenant une fonction isocyanate comme décrit ci-dessus dans des compositions réticulables/polymérisables sous irradiation. Elle concerne en particulier l'utilisation dans de telles compositions utilisées en tant que vernis, adhésif, encre ou peinture.

D'autres détails ou avantages de l'invention apparaîtront plus clairement à la vue des exemples donnés ci-dessous uniquement à titre indicatif.

### Tests

*Test à la MEK :* On dépose une goutte de méthyl-éthyl-cétone (MEK) sur le film de vernis. On pose par-dessus un verre de montre, et on laisse agir pendant 3 minutes. Après, on élimine le produit en tamponnant légèrement avec un chiffon doux, puis on examine l'état de la surface du film. On cote le résultat de 0 à 5, 0 correspondant à un effet nul, et 5 correspondant à la destruction complète du film :
   0 : Le film n'est pas attaqué, le réactif ne laisse aucune trace.
   1 : On observe une marque correspondant au pourtour de la goutte. La partie intérieure est identique au reste du film en aspect et au toucher.
   2 : On observe une perte de brillance, ou que le film est happant (très ramolli), ou une coloration.
   3 : Le film cumule 2 ou 3 des défauts de la note 3.
   4 : Le film est plissé ou poisseux sans vraiment de cohésion. On peut aussi observer un bourrelet à la périphérie de la goutte.
   5 : Le film a été complètement détruit, le support est à nu.
*Flexibilité des couches ("T-bend")* : On découpe une bandelette de 5 à 10 mm de large du support vernis, et on replie une extrémité sur la bandelette, face vernis toujours à l'extérieur. En continuant de replier de la même façon la même extrémité, la pliure est de moins en moins franche, et à un certain point le revêtement ne présente aucune marque due à la pliure (fissure, craquelure...). Le résultat du test est le nombre de tours effectués par l'extrémité pour arriver à ce point (2,5 = 2 tours plus un demi-tour = 5 pliures consécutives).
*Dureté :* Il est ici fait mention de dureté crayon. Elle est mesurée à l'aide d'un jeu standard de crayons allant de dureté 7B à 7H.

### EXEMPLES

Dans les exemples, on utilise comme composés de base A les monomères suivants :

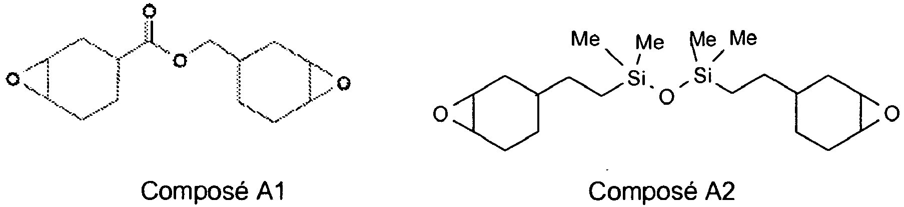

On utilise aussi comme composé B le photoamorceur de structure suivante :

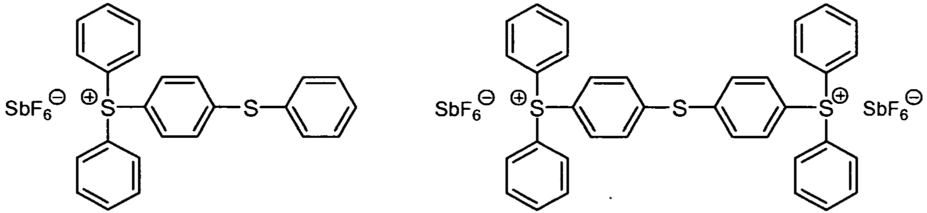

C'est un mélange de sels type hexafluoroantimonate d'arylsulfonium.

Comme composé C on utilise de l'alcool benzylique.

Comme composé D, on utilise des oligomères d'hexaméthylène-diisocyanate (HDI) commercialisés par Rhodia sous le nom de marque Tolonate®. On donne ci après les principales caractéristiques de ceux-ci :

| Composé | Nom du produit | Viscosité (mPa.s) | Teneur en fonctions isocyanates (% poids exprimé en NCO) |
|---|---|---|---|
| D1 | Tolonate HDT | 2400 | 22.0 |
| D2 | Tolonate HDT-LV | 1200 | 23.0 |
| D3 | Tolonate HDT-LV2 | 600 | 23.0 |
| D4 | Tolonate XFD90B | 2000 | 17.4 |

### Exemple comparatif

On effectue le mélange des constituants suivants :

| Produit | Quantité (g) |
|---|---|
| Composé A1 | 80 |
| Composé C | 10 |
| Composé B | 5 |

On obtient une solution incolore et limpide.

L'application sur plaque aluminium (type Péchiney pour canettes) à l'aide d'une barre d'enduction filetée type Meyer n°2 conduit à un film homogène sans démouillage. Après passage sous UV (vitesse 10m/min sous 2 lampes mercure à 190W/cm), on obtient un film sec au toucher d'une épaisseur de 5µm environ.

### Exemple 1

On effectue le mélange des constituants suivants :

| Produit | Quantité (g) |
|---|---|
| Composé A1 | 80 |
| Composé C | 10 |
| Composé D2 | 10 |
| Composé B | 5 |

On obtient une solution incolore et limpide.

L'application sur plaque aluminium (type Péchiney pour canettes) à l'aide d'une barre d'enduction filetée type Meyer n°2 conduit à un film homogène sans démouillage. Après passage sous UV (vitesse 10m/min sous 2 lampes mercure à 190W/cm), on obtient un film sec au toucher d'une épaisseur de 5µm environ.

La même formulation est appliquée de la même manière sur un autre support vierge 4 heures et 24 heures après sa préparation. Après passage sous UV (vitesse 10m/min sous 2 lampes mercure à 190W/cm), on obtient de nouveau un film sec au toucher d'une épaisseur de 5µm environ.

On peut aussi après irradiation UV terminer la réticulation par cuisson dans une étude à 200°C pendant 1 min. Les films obtenus possèdent alors les propriétés suivantes :

| Formulation | Exemple comparatif | Exemple 1 |
|---|---|---|
| Etat du film | R | R |
| MEKàT+1h | 0 | 0 |
| Dureté à J + 7 | 2H | H |
| T-bend à J + 7 | 2.5 | 0.5 |

| | | |
|---|---|---|
| (R = réticulé, LC = légèrement collant, C = collant, NR = non réticulé) (Test à la MEK : 0 = pas de dégradation, 5 = complète destruction du film) | | |

On constate une nette amélioration de la souplesse du revêtement, sans détérioration des autres propriétés.

### Exemples 2 à 5

On prépare des compositions dont la proportion de chaque composé est indiquée dans le tableau ci-dessous :

| Exemple | 2 | 3 | 4 | 5 |
|---|---|---|---|---|
| Produit | Quantité (g) | Quantité (g) | Quantité (g) | Quantité (g) |
| Composé A1 | 15.5 | 15.5 | 15.5 | 15.5 |
| Composé C | 1.7 | 1.7 | 1.7 | 1.7 |
| Composé D1 | 2.95 | | | |
| Composé D2 | | 2.95 | | |
| Composé D3 | | | 2.9 | |
| Composé D4 | | | | 3.23 |
| Composé B | 0.7 | 0.7 | 0.7 | 0.7 |

L'application sur plaque aluminium (type Péchiney pour canettes) à l'aide d'une barre d'enduction filetée type Meyer n°2 conduit à des films homogènes sans démouillage. Après passage sous UV (vitesse 10m/min sous 2 lampes mercure à 190W/cm), puis cuisson 1 min dans une étuve à 200°C, on obtient un film sec au toucher d'une épaisseur de 5µm environ.

Les propriétés finales sont résumées dans le tableau ci-dessous :

| Exemple | 2 | 3 | 4 | 5 |
|---|---|---|---|---|
| Etat du film | R | R | R | R |
| MEK | 1 | 0 | 1 | 1 |
| Dureté | H | H | 2H | H |
| T-bend | 0.5 | 0.5 | 0.5 | 0.5 |

| | | | | |
|---|---|---|---|---|
| (R = réticulé, LC = légèrement collant, C = collant, NR = non réticulé) (Test à la MEK : 0 = pas de dégradation, 5 = complète destruction du film) | | | | |

### Exemple 6

On effectue le mélange des constituants suivants :

| Produit | Quantité (g) |
|---|---|
| Composé A2 | 80 |
| Composé C | 10 |
| Composé D2 | 10 |
| Composé B | 5 |

On obtient une solution incolore et limpide.

L'application sur plaque aluminium (type Péchiney pour canettes) à l'aide d'une barre Meyer n°2 conduit à un film homogène sans démouillage. Après passage sous UV (vitesse 10m/min sous 2 lampes mercure à 190W/cm), on obtient un film sec au toucher d'une épaisseur de 5µm environ.

## Revendications

1. Composition polymérisable et/ou réticulable sous irradiation, de préférence actinique et/ou par faisceau (x) d'électrons, par voie cationique et/ou radicalaire comprenant :
(A) au moins un composé de base comportant, par molécule, au moins un groupement de polymérisation/réticulation, les groupements étant choisis dans la liste suivante : époxy, oxétanne, alcényle, dioxolanne, episulfure, thioxolanne, acrylate ou méthacrylate, hydroxy ;
(B) au moins un photoamorceur cationique et/ou radicalaire ;
(C) éventuellement au moins un composé comprenant une fonction alcool ou thiol ou acide carboxylique ;
**caractérisée en ce qu'**elle comprend
(D) au moins un composé comprenant au moins une fonction isocyanate.

2. Composition selon la revendication 1, **caractérisée en ce qu'**elle est polymérisable et/ou réticulable par voie cationique.

3. Composition selon la revendication 1 ou 2, **caractérisée en ce que** le composé de base comprend au moins deux groupements de polymérisation/réticulation ou deux groupements étant de polymérisation/réticulation sélectionnés dans le groupe des associations de groupements suivantes époxy-époxy, oxétanne-oxétanne, dioxolanne-dioxolanne.

4. Composition selon l'une des revendications précédentes, **caractérisée en ce que** le composé de base avec des groupements époxy est sélectionné parmi les composés suivants :

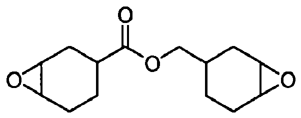

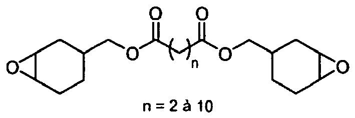

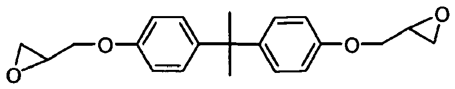

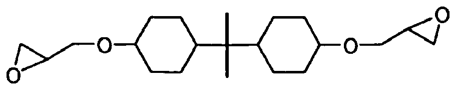

5. Composition selon l'une des revendications précédentes, **caractérisée en ce que** le composé de base est un oligomère et/ou polymère silicone réticulable et/ou polymérisable liquide à température ambiante ou thermofusible à température inférieure à 100° C, l'oligomère et/ou polymère silicone comprenant au moins deux atomes de silicium et au moins un motif de formule suivante:
Z(R⁰)ₐSiO_{3-a/2}
dans laquelle
- a = 0, 1 ou 2,
- R⁰, identique ou différent, représente un radical alkyle, cycloalkyle, aryle, vinyle, hydrogéno, hydroxy, alcoxy, de préférence un alkyle inférieur en C₁-C₆,
- Z, est un substituant organique comportant au moins une fonction réactive époxy, et/ou alcénylether et/ou oxétanne et/ou dioxolane et/ou carbonate.

6. Composition selon l'une des revendications précédentes, **caractérisée en ce que** le groupement alcényle est un alcényléther.

7. Composition selon l'une des revendications précédentes, **caractérisée en ce que** le composé (C) comprend une fonction thiol ou alcool.

8. Composition selon l'une des revendications précédentes, **caractérisée en ce que** le composé comprenant une fonction isocyanate est un polyisocyanate de formule (I) :
Y-(-N=C=O)ₙ
dans laquelle Y est un groupement polyvalent substitué ou non, comprenant ou non des hétéroatomes, aromatique, aliphatique, cycloaliphatique ou hétérocyclique et n est au moins égal à 1.

9. Composition selon la revendication 8, **caractérisée en ce que** le polyisocyanate est un diisocyanate ou un triisocyanate.

10. Procédé de revêtement d'un support, **caractérisé en ce que** l'on applique la composition selon l'une des revendications 1 à 9 sur un support.

11. Procédé selon la revendication 10, **caractérisé en ce qu'**il comprend les étapes suivantes
- enduire le support à l'aide de la composition selon l'une des revendications 1 à 9 pour former au moins une couche (au moins partielle) de revêtement sur le support,
- faire réticuler la couche de revêtement sous irradiation.

12. Composite susceptible d'être obtenu par le procédé selon la revendication 10 ou 11, **caractérisé en ce qu'**il comprend
- un support,
- au moins une couche de revêtement (au moins partielle) obtenue à partir de la composition selon l'une des revendications 1 à 9.

13. Article manufacturé, **caractérisé en ce qu'**il comporte du composite selon la revendication 12.

14. Article manufacturé selon la revendication 13, **caractérisé en ce qu'**il s'agit d'une boite d'emballage métallique.

15. Utilisation de la composition selon l'une des revendications 1 à 9 comme vernis.

16. Utilisation de la composition selon l'une des revendications 1 à 9 comme vernis pour boite d'emballage métallique.

17. Utilisation de la composition selon l'une des revendications 1 à 9 comme adhésif, encre ou peinture.

18. Utilisation d'un composé comprenant une fonction isocyanate tel que défini dans les revendications 1 à 9 dans des compositions selon les revendications 1 à 9 réticulables/polymérisables sous irradiation.

19. Utilisation selon la revendication 18, **caractérisée en ce que** la composition est une composition pour vernis, encre, adhésif ou peinture.

## Patentansprüche

1. Zusammensetzung, die durch Bestrahlung, vorzugsweise aktinische und/oder durch einen Elektronenstrahl (en), kationisch und/oder radikalisch polymerisierbar und/oder vernetzbar ist, umfassend:
(A) mindestens eine Grundverbindung, die pro Molekül mindestens eine Polymerisations-/Vernetzungsgruppe aufweist, wobei die Gruppen aus der folgenden Liste ausgewählt sind: Epoxy, Oxetan, Alkenyl, Dioxolan, Episulfid, Thioxolan, Acrylat oder Methacrylat, Hydroxy;
(B) mindestens einen kationischen und/oder radikalischen Photoinitiator;
(C) gegebenenfalls mindestens eine Verbindung, die eine Alkohol- oder Thiol- oder Carboxylfunktion umfasst;
**dadurch gekennzeichnet, dass** sie umfasst
(D) mindestens eine Verbindung, die mindestens eine Isocyanatfunktion umfasst.

2. Zusammensetzung nach Anspruch 1, **dadurch gekennzeichnet, dass** sie kationisch polymerisierbar und/oder vernetzbar ist.

3. Zusammensetzung nach Anspruch 1 oder 2, **dadurch gekennzeichnet, dass** die Grundverbindung mindestens zwei Polymerisations-/Vernetzungsgruppen umfasst, oder diese zwei Polymerisations-/Vernetzungsgruppen ausgewählt sind aus der Gruppe der folgenden Kombinationen von Gruppen Epoxy-Epoxy, Oxetan-Oxetan, Dioxolan-Dioxolan,

4. Zusammensetzung nach einem der vorhergehenden Ansprüche, **dadurch gekennzeichnet, dass** die Grundverbindung mit Epoxygruppen aus den folgenden Verbindungen ausgewählt ist:

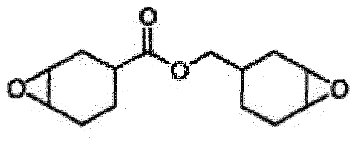

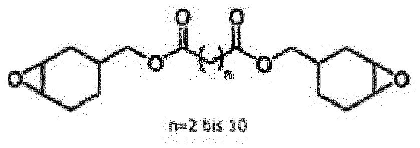

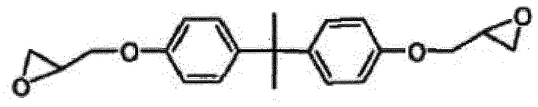

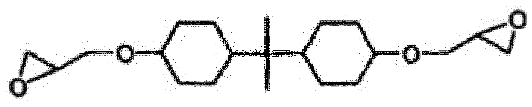

5. Zusammensetzung nach einem der vorhergehenden Ansprüche, **dadurch gekennzeichnet, dass** die Grundverbindung ein vernetzbares und/oder polymerisierbares Silikonoligomer und/oder -polymer ist, das bei Umgebungstemperatur flüssig oder bei einer Temperatur kleiner als 100°C thermisch schmelzbar ist, wobei das Silikonoligomer und/oder -polymer mindestens zwei Siliziumatome und mindestens eine Einheit der folgenden Formel umfasst:
Z(R⁰)ₐSiO_{3-a/2},
bei der
- a = 0,1 oder 2,
- R⁰, identisch oder unterschiedlich, ein Alkyl-, Cycloalky-, Aryl-, Vinyl-, Hydrogen-, Hydroxy-, Alkoxy-Radikal, vorzugsweise ein niederes C₁-C₆ -Alkyl darstellt,
- Z ein organischer Substituent ist, der mindestens eine reaktive Epoxy- und/oder Alkenylether- und/oder Oxetan- und/oder Dioxolan- und/oder Carbonatfunktion aufweist.

6. Zusammensetzung nach einem der vorhergehenden Ansprüche, **dadurch gekennzeichnet, dass** die Alkenylgruppe ein Alkenylether ist.

7. Zusammensetzung nach einem der vorhergehenden Ansprüche, **dadurch gekennzeichnet, dass** die Verbindung (C) eine Thiol- oder Alkoholfunktion umfasst.

8. Zusammensetzung nach einem der vorhergehenden Ansprüche, **dadurch gekennzeichnet, dass** die Verbindung, die eine Isocyanatfunktion umfasst, ein Polyisocyanat der der Formel (I) ist:
Y-(-N=C=O)ₙ
bei der Y eine polyvalente Gruppe, substituiert oder nicht, ist, die aromatische, aliphatische, cycloaliphatische oder heterocyklische Heteroatome umfasst oder nicht, und n mindestens gleich 1 ist.

9. Zusammensetzung nach Anspruch 8, **dadurch gekennzeichnet, dass** das Polyisocyanat ein Diisocyanat oder ein Triisocyanat ist.

10. Verfahren zum Beschichten einer Trägers, **dadurch gekennzeichnet, dass** die Zusammensetzung nach einem der Ansprüche 1 bis 9 auf einen Träger aufgebracht wird.

11. Verfahren nach Anspruch 10, **dadurch gekennzeichnet, dass** es die folgenden Schritte aufweist
- Beschichten des Trägers mit Hilfe der Zusammensetzung nach einem der Ansprüche 1 bis 9, um mindestens eine Überzugsschicht (mindestens teilweise) auf dem Träger zu bilden,
- Vernetzen der Überzugsschicht unter Bestrahlung.

12. Verbundteil, das durch das Verfahren nach dem Anspruch 10 oder 11 erhalten werden kann, **dadurch gekennzeichnet, dass** es umfasst
- einen Träger,
- mindestens eine Überzugsschicht (mindestens teilweise), die mit der Zusammensetzung nach einem der Ansprüche 1 bis 9 erhalten wird.

13. Fertigungsgegenstand, **dadurch gekennzeichnet, dass** es ein Verbundteil nach Anspruch 12 aufweist.

14. Fertigungsgegenstand nach Anspruch 13, **dadurch gekennzeichnet, dass** es sich um einen Verpackungsbehälter aus Metall handelt.

15. Verwendung der Zusammensetzung nach einem der Ansprüche 1 bis 9 als Lack.

16. Verwendung der Zusammensetzung nach einem der Ansprüche 1 bis 9 als Lack für Verpackungsbehälter aus Metall.

17. Verwendung der Zusammensetzung nach einem der Ansprüche 1 bis 9 als Klebstoff, Tinte oder Farbe.

18. Verwendung einer durch Bestrahlung vernetzbaren/polymerisierbaren, eine Isocyanatfunktion enthaltenden Verbindung, wie sie in den Ansprüchen 1 bis 9 in Zusammensetzungen nach den Ansprüchen 1 bis 9 definiert ist.

19. Verwendung nach Anspruch 18, **dadurch gekennzeichnet, dass** die Zusammensetzung eine Zusammensetzung für Lack, Tinte, Klebstoff oder Farbe ist.

## Claims

1. Composition that can be polymerised and/or cross-linked by exposure to irradiation, preferably actinic radiation and/or to electron beam(s) irradiation, by cationic and/or radical route comprising:
(A) at least one base compound comprising per molecule at least one polymerisation/cross-linkage group, wherein the groups are selected from the following list: epoxy, oxetane, alkenyl, dioxolane, episulphide, thioxolane, acrylate or methacrylate, hydroxy;
(B) at least one cationic and/or radical photoinitiator;
(C) possibly at least one compound comprising an alcohol or thiol or carboxylic acid functional group;
**characterised in that** it comprises
(D) at least one compound comprising at least one isocyanate functional group.

2. Composition according to claim 1, **characterised in that** it is polymerisable and/or cross-linkable by cationic route.

3. Composition according to claim 1 or 2, **characterised in that** the base compound comprises at least two polymerisation and/or cross-linkage groups, or two polymerisation and/or cross-linkage groups being selected from the group of the following group combinations epoxy-epoxy, oxetane-oxetane, dioxolane-dioxolane.

4. Composition according to one of the preceding claims, **characterised in that** the base compound with the epoxy groups is selected from the following compounds: [n = 2 to 10]

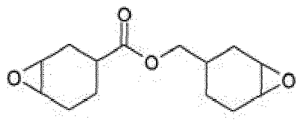

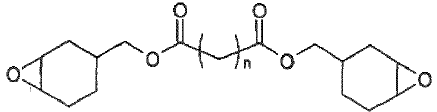

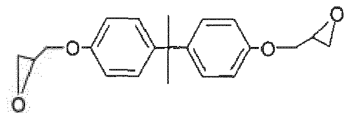

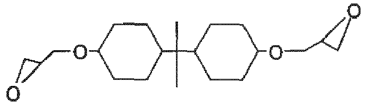

5. Composition according to one of the preceding claims, **characterised in that** the base compound is an oligomer and/or silicone polymer that is cross-linkable and/or polymerisable and liquid at ambient temperature or hot-meltable at a temperature of less than 100°C, wherein the oligomer and/or silicone polymer comprises at least two silicon atoms and at least one unit of the following formula:
Z(R⁰)ₐSiO_{3-a/2},
in which
• a=0, 1 or 2,
• R⁰, identical or different, represents an alkyl, cycloalkyl, aryl, vinyl, hydrogen, hydroxy, alkoxy radical, preferably a C₁-C₆ lower alkyl,
• Z is an organic substituent comprising at least one epoxy and/or alkenyl ether and/or oxetane and/or dioxolane and/or carbonate reactive functional group.

6. Composition according to one of the preceding claims, **characterised in that** the alkenyl group is an alkenyl ether.

7. Composition according to one of the preceding claims, **characterised in that** the compound (C) comprises a thiol or alcohol functional group.

8. Composition according to one of the preceding claims, **characterised in that** the compound comprising an isocyanate functional group is a polyisocyanate of formula (I):
Y-(-N=C=O)ₙ
in which Y is a substituted or unsubstituted polyvalent aromatic, aliphatic, cycloaliphatic or heterocyclic group that may or may not comprise heteroatoms, and n is at least equal to 1.

9. Composition according to claim 8, **characterised in that** the polyisocyanate is a diisocyanate or a triisocyanate.

10. Method for coating a support, **characterised in that** the composition according to one of claims 1 to 9 is applied to a support.

11. Method according to claim 10, **characterised in that** it comprises the following steps
• coating the support by means of the composition according to one of claims 1 to 9 to form at least one (at least partial) covering layer on the support,
• cross-linking the covering layer by irradiation.

12. Composite that can be obtained by the method according to claim 10 or 11, **characterised in that** it comprises
• a support
• at least one (at least partial) covering layer obtained from the composition according to one of claims 1 to 9.

13. Manufactured article, **characterised in that** it comprises some composite according to claim 12.

14. Manufactured article according to claim 13, **characterised in that** this is a metal packaging box.

15. Use of the composition according to one of claims 1 to 9 as varnish.

16. Use of the composition according to one of claims 1 to 9 as varnish for a metal packaging box.

17. Use of the composition according to one of claims 1 to 9 as adhesive, ink or paint.

18. Use of a compound comprising an isocyanate functional group as defined in claims 1 to 9 in compositions according to claims 1 to 9 that can be cross-linked/polymerised by irradiation.

19. Use according to claim 18, **characterised in that** the composition is a composition for varnish, ink, adhesive or paint.
